# EUROPEAN PATENT APPLICATION

(11) **EP 2 495 737 A1**
(43) Date of publication of application: **05.09.2012**
(21) Application number: 10826864.0
(22) Date of filing: 29.10.2010
(51) Int. Cl.: H01B 13/00, C01F 5/02, C01G 1/00, H01B 12/06

(54) **SUBSTRATE FOR OXIDE SUPERCONDUCTOR AND PROCESS FOR PRODUCING SAME, AND OXIDE SUPERCONDUCTOR AND PROCESS FOR PRODUCING SAME**

(30) Priority: 30.10.2009 JP 2009250488
(71) Applicant: INTERNATIONAL SUPERCONDUCTIVITY TECHNOLOGY CENTER, Tokyo 135-0062 (JP); Fujikura, Ltd., Tokyo 135-8512 (JP); Furukawa Electric Co., Ltd., Chiyoda-ku Tokyo 100-8322 (JP)
(72) Inventor: YOSHIZUMI Masateru, Tokyo 135-0062 (JP); FUKUSHIMA Hiroyuki, Tokyo 100-8322 (JP); HATAKEYAMA Hideyuki, Tokyo 135-0062 (JP); YAMADA Yutaka, Tokyo 135-0062 (JP); TOBITA Hiroshi, Tokyo 135-0062 (JP); IZUMI Teruo, Tokyo 135-0062 (JP)
(74) Representative: Hodsdon, Stephen James
(86) International application number: PCT/JP2010/069320
(87) International publication number: WO 2011/052734

(57) **Abstract**

A substrate for an oxide superconductor including: a metal base; an interlayer of MgO formed on the metal base by ion beam assisted deposition method (IBAD METHOD); and a cap layer that is formed directly on the interlayer and has a higher degree of crystal orientation than that of the interlayer, in which the interlayer of MgO is subjected to a humidity treatment prior to formation of the cap layer.

## Description

### TECHNICAL FIELD

The present invention relates to technology that can easily provide a cap layer with good orientation that serves as a foundation for obtaining an oxide superconductor with excellent superconducting properties, in a structure that provides an interlayer and a cap layer on a metal base, with an oxide superconductor layer laminated on the cap layer to become a substrate of an oxide superconductor.
Priority is claimed on Japanese Patent Application No. 2009-250488, filed October 30, 2009, the content of which is incorporated herein by reference.

### BACKGROUND ART

An oxide superconductor such as an RE-123-based oxide superconductor (REBa₂Cu₃O₇₋ₙ: RE being any rare earth that includes Y) exhibits an excellent superconductive property at liquid nitrogen temperatures and above, and so is regarded as an extremely promising material in practice. In particular, there is a demand for the oxide superconductor to be processed into a wire for use as a superconductor for electrical power supply.
To manufacture an RE-123-based oxide superconductor, it is necessary to form an oxide superconductor layer with a good crystal orientation on a substrate with a high degree of crystal orientation. The crystal of this kind of oxide superconductor has electrical anisotropy depending on the directions of the crystal axes. For this reason, in the case of forming an oxide superconductor layer using such a crystal, the crystal orientation needs to be excellent, and also for a substrate that serves as a foundation for forming an oxide superconductor layer, the crystal orientation needs to be excellent.

As a configuration that is used for such kind of RE-123-based oxide superconductor, a structure is known in which an interlayer 102 that is formed by ion beam assisted deposition (IBAD method), a cap layer 103 that is formed thereon, and an oxide superconductor layer 104 that is formed on the cap layer 103 are laminated on a tape-like metal base 101 as shown in FIG. 7 (for example, refer to Patent Document 1).
In the structure, the higher the crystal in-plane orientation of the cap layer 103, the higher the crystal in-plane orientation of the oxide superconductor layer 104 that is formed thereon. The higher the crystal in-plane orientation of the oxide superconductor layer 104, the better the superconducting properties, such as the critical current density and the like, of the oxide superconductor that is obtained.
Hereinbelow, the interlayer 102 that is formed by IBAD method and the orientation mechanism thereof shall be described.

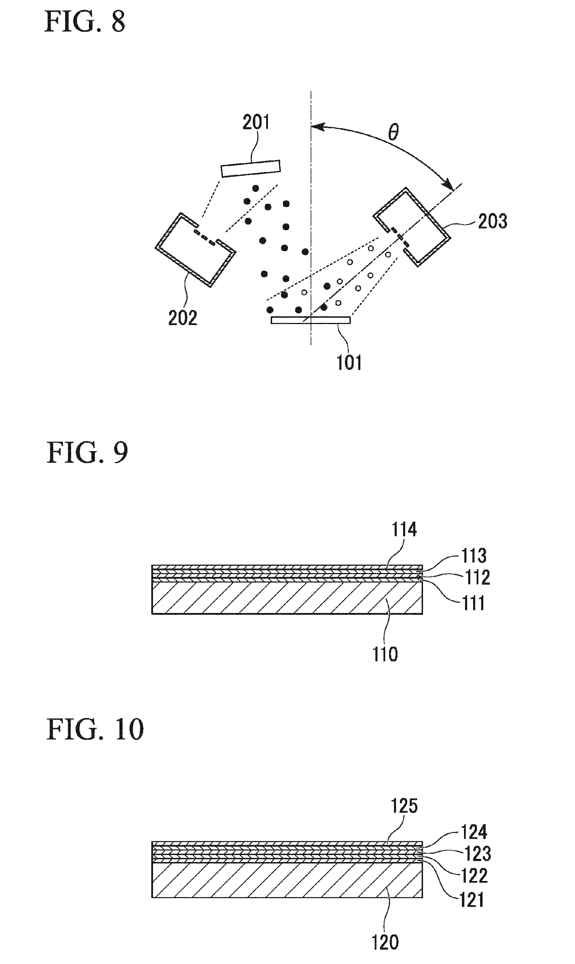

As shown in FIG. 8, an interlayer formation device using IBAD method includes a travel system for moving a metal base 101 in the lengthwise direction thereof, a target 201 whose surface is made to obliquely face the surface of the metal base 101, a sputtering beam radiating device 202 that radiates ions to the target 201, and an ion source 203 that radiates ions in an oblique direction to the surface of the metal base 101 (mixed ions of rare gas ions and oxygen ions), and these components are arranged in a vacuum container (not illustrated).

To form the interlayer 102 on the metal base 101 using the interlayer formation device, the interior of the vacuum container is made a reduced-pressure atmosphere, and the sputtering beam radiating device 202 and the ion source 203 are put into operation. Thereby, ions are radiated from the sputtering beam radiating device 202 to the target 201, and the constituent particles of the target 201 are sputtered or evaporated and are deposited on the metal base 101. Simultaneously, mixed ions of rare gas ions and oxygen ions are emitted from the ion source 203, and these mixed ions are radiated at a predetermined incident angle (θ) to the surface of the metal base 101.
In this manner, by performing ion radiation at a predetermined incident angle while depositing the constituent particles of the target 201 on the surface of the metal base 101, a specified crystal axis of the formed sputtering film is fixed in the ion incident direction. As a result, the c axis of the crystal is oriented in the perpendicular direction with respect to the surface of the metal base 101, while the a axis and the b axis of the crystal are oriented in given directions within the plane of the sputtering film. For that reason, the interlayer 102 that is formed by IBAD method has a high degree of in-plane orientation.

On the other hand, the cap layer 103 is constituted by a material, such as CeO₂, which can be epitaxially grown on the surface of the interlayer 102 with the in-plane crystal axes oriented as described above and the crystal grains of which can be grown in the lateral direction and exhibit self-epitaxy in the in-plane direction. Since the cap layer 103 exhibits self-epitaxy in this way, it is possible to obtain a higher degree of in-plane orientation than that of the interlayer 102. Accordingly, when the oxide superconductor layer 104 is formed via the interlayer 102 and the cap layer 103 on the metal base 101, the oxide superconductor layer 104 is epitaxially grown so as to fit together with the crystal orientation of the cap layer 103 that has a high degree of in-plane orientation. For this reason, the oxide superconductor layer 104 is obtained with excellent superconducting properties such as an excellent in-plane orientation and large critical current density.

### [Prior Art Documents]

### [Patent Document]

[Patent Document 1] Japanese Unexamined Patent Application, First Publication No. 2004-71359

### DISCLOSURE OF INVENTION

### PROBLEMS TO BE SOLVED BY THE INVENTION

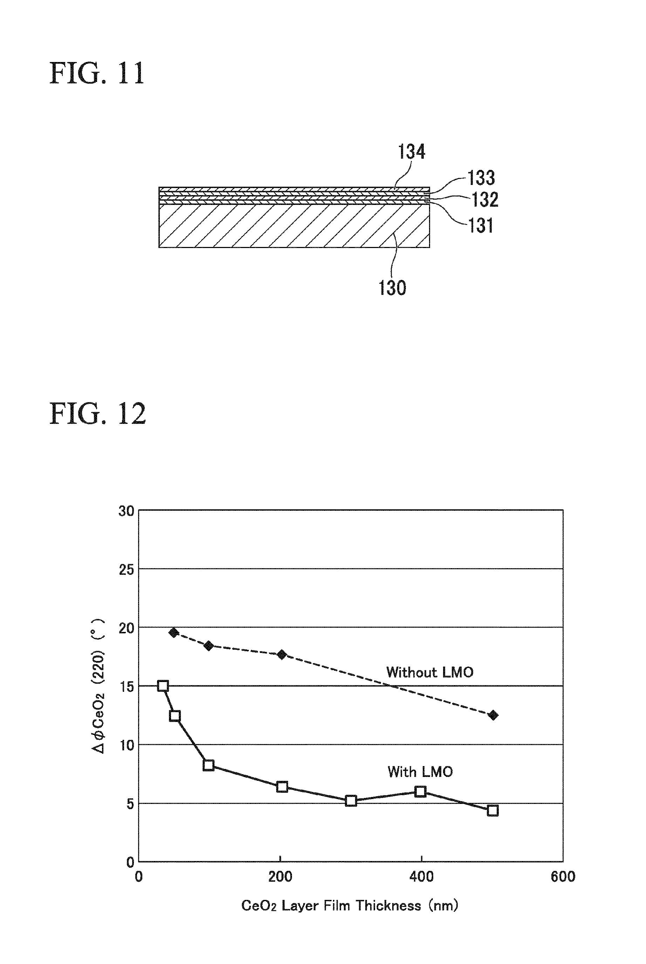

Presently, from the aforementioned technical background, as a structural example of a substrate used for a foundation for an oxide superconductor layer, a structure is known, the structure including a diffusion prevention layer 111 of aluminum oxide (Al₂O₃), a bed layer 112 of yttria (Y₂O₃), an interlayer 113 of MgO that is formed by IBAD method (hereinbelow referred to as an interlayer of IBAD-MgO), and a cap layer 114 of CeO₂, provided on a metal base 110 with the oxide superconductor layer formed on the cap layer 114 as shown in FIG. 9.
Also, a structure is known, the structure including a diffusion prevention layer 121 of aluminum oxide (Al₂O₃) that is formed by sputtering, a bed layer 122 of yttria (Y₂O₃) that is formed by sputtering, an interlayer 123 of IBAD-MgO, an MgO layer 124 that is formed by sputtering and epitaxially grown, and a cap layer 125 of LMO (LaMnO₃) provided on a metal base 120, with the oxide superconductor layer formed on the cap layer 125 as shown in FIG. 10.
Also, a structure is known, the structure including an orientation adjustment layer 131 of GZO (Gd₂Zr₂O₇) that is formed by sputtering, an interlayer 132 of IBAD-MgO, a foundation layer 133 of LMO (LaMnO₃), and a cap layer 134 of Ce0₂ provided on the metal base 130, with the oxide superconductor layer formed on the cap layer 134 as shown in FIG. 11.

In these conventional substrate laminate structures of an oxide superconductor, in consideration of the lattice matching of the crystal, the configuration in which a cap layer of CeO₂ is provided directly under the oxide superconductor layer is adopted in most cases. Since the crystal orientation of the interlayer of IBAD-MgO that serves as the foundation of the cap layer of CeO₂ is also important, in the case of the crystal orientation of the interlayer of IBAD-MgO being comparatively low, a structure is adopted in which a foundation of LMO (LaMnO₃) is further provided on the interlayer of IBAD-MgO to improve the orientation of the cap layer of CeO₂.
Comparing the case of an LMO foundation layer existing, and the case of an LMO foundation layer not existing in the substrate structure for an oxide superconductor, as in FIG. 12, a significant difference is found in the orientation of the cap layer of CeO₂ that is formed thereon. By laminating a cap layer of CeO₂ with a thickness of 200 to 500 nm on the LMO foundation layer, it is possible to obtain a cap layer of CeO₂ with the intended degree of orientation of around 5°. By epitaxially forming the oxide superconductor layer on the cap layer of CeO₂ with the degree of orientation of around 5°, the intended oxide superconductor layer with a high critical current density is obtained.

However, in any of the substrate structures for an oxide superconductor shown in FIG. 9 to FIG. 11, unless a plurality of layers are so skillfully laminated to improve the crystal in-plane orientation degree, there is the problem of not being able to obtain 5° as the orientation degree of the layer immediately below the oxide superconductor. In order to lower the manufacturing costs of the oxide superconductor, it is necessary to achieve the target orientation degree of around 5° in a structure with as few laminated layers as possible.
Here, the inventors arrived at the present invention through various types of research to see whether it is possible to attain an orientation effect by self-epitaxy of the cap layer of CeO₂ without an LMO foundation layer, in order to realize a layered structure with an orientation degree of the cap layer of around 5°, for example, 7° or less, in a substrate structure for an oxide superconductor.

The present invention has an object of providing technology that is capable of obtaining excellent crystal orientation without using an LMO foundation layer, which has conventionally been required for the cap layer with a high orientation degree serving as the foundation of an oxide superconductor. Also, the present invention has another object of providing technology that is capable of simplifying and lowering the cost of the manufacturing process of a substrate for an oxide superconductor by reducing the number of laminations of the substrate for an oxide superconductor, in which a cap layer with excellent crystal orientation can be obtained without using an LMO foundation layer.
The present invention has another object of providing an oxide superconductor which includes: a cap layer with excellent crystal orientation that serves as the foundation of the oxide superconductor layer without using an LMO foundation layer; and thereon an oxide superconductor layer with excellent crystal orientation, and providing a method for manufacturing the same. Also, the present invention has another object of providing technology that is capable of simplifying and lowering the cost of the manufacturing process of an oxide superconductor by reducing the number of laminations of the oxide superconductor, since it is possible to obtain a cap layer with excellent crystal orientation without using an LMO foundation layer.

### MEANS FOR SOLVING THE PROBLEMS

The present invention has the following configurations in order to solve the aforementioned problems.
(1) A substrate for an oxide superconductor according to an aspect of the present invention includes: a metal base; an interlayer of MgO formed on the metal base by ion beam assisted deposition method (IBAD METHOD); and a cap layer that is formed directly on the interlayer and has a higher degree of crystal orientation than that of the interlayer, in which the interlayer of MgO is subjected to a humidity treatment prior to formation of the cap layer.
(2) A substrate for an oxide superconductor according to another aspect of the present invention includes: a metal base; an interlayer of MgO formed on the metal base by ion beam assisted deposition method (IBAD METHOD); and a cap layer that is formed directly on the interlayer and has a higher degree of crystal orientation than that of the interlayer, wherein a hydroxide of Mg exists in the interface between the interlayer of MgO and the cap layer.

(3) It may be arranged such that Mg(OH)₂ or MgCO₃ exists in the interface between the interlayer of MgO and the cap layer, or the grain boundary of MgO.
(4) It may be arranged such that a bed layer of oxide is interposed between the metal base and the interlayer.
(5) It may be arranged such that the value of the half-value width (FWHM: full width at half maximum) ΔΦ of the crystal axis dispersion in the in-plane direction, which is an index representing the in-plane crystal orientation of the cap layer, is 7° or less at ΔΦ (220).
(6) It may be arranged such that the humidity treatment is a treatment that is performed in an atmosphere including moisture.
(7) It may be arranged such that the cap layer is CeO₂.

(8) A process for producing a substrate for an oxide superconductor according to another aspect of the present invention includes: a metal base; an interlayer of MgO formed on the metal base by ion beam assisted deposition method (IBAD METHOD); and a cap layer that is formed directly on the interlayer and has a higher degree of crystal orientation than that of the interlayer, the process for producing a substrate for an oxide superconductor including: forming a laminate by forming the interlayer of MgO on the metal base; performing a humidity treatment on the laminate; and forming the cap layer directly on the interlayer of MgO.
(9) It may be arranged such that the humidity treatment is performed in an atmosphere that includes moisture.
(10) It may be arranged such that the humidity treatment is performed for 10 minutes or more in an atmosphere of a 60% to 90% humidity and a temperature range of 25°C to 60°C.

(11) It may be arranged such that the cap layer is formed from CeO₂.
(12) An oxide superconductor according to another aspect of the present invention includes: any of the substrates for an oxide superconductor described above; and the oxide superconductor layer that is formed on the substrate for an oxide superconductor.
(13) A process for producing an oxide superconductor according to another aspect of the present invention includes forming an oxide superconductor layer on any of the substrates for an oxide superconductor.

### EFFECTS OF THE INVENTION

Based on the substrate for an oxide superconductor according to (1) above, since the cap layer of CeO₂ or the like is formed on the interlayer of IBAD-MgO subjected to humidity treatment, even without a foundation layer of LMO (LaMnO₃) that is provided on the interlayer of IBAD-MgO in a conventional structure, a cap layer having excellent self-epitaxy is obtained by the structure according to the present invention. Accordingly, it is possible to provide a substrate for an oxide superconductor in which the crystal in-plane orientation of the cap layer is excellent. Moreover, since it is possible to omit the foundation layer of LMO (LaMnO₃) that is provided on the interlayer of BAD- MGO in a conventional structure, the number of laminated layers is fewer, and so it is possible to provide a substrate for an oxide superconductor that can be made cheaper.
Accordingly, it is possible to provide an oxide superconductor with excellent superconductivity including critical current density by providing an oxide superconductor layer on the cap layer having excellent crystal in-plane orientation.

As for the reason for the improvement in the crystal in-plane orientation of the cap layer that is provided on the interlayer of IBAD-MgO by performing the humidity treatment, an association is presumed in the generation of a hydroxide of Mg on the interlayer of IBAD-MgO by the humidity treatment. This is because the crystal in-plane orientation of the cap layer of CeO₂ or the like that is laminated thereon improves by the generation of the hydroxide of Mg on the interlayer of IBAD-MgO by the humidity treatment.
Also, due to the existence of the hydroxide of Mg in the interface between the interlayer of IBAD-MgO and the cap layer thereon or the grain boundary of MgO, it is possible to improve the crystal in-plane orientation of the cap layer of CeO₂ or the like that is laminated on the interlayer of IBAD-MgO.

By developing excellent self-epitaxy of the cap layer, it is possible to obtain 7° or less at ΔΦ (220) as the half-value width (full width at half maximum (FWHM)) ΔΦ of the crystal axis dispersion in the in-plane direction, which is an index representing the in-plane crystal orientation of the cap layer.
The humidity treatment may be a treatment that exposes the interlayer of IBAD-MgO to inert gas including moisture, and may be a treatment that exposes the interlayer of IBAD-MgO to an atmosphere such as air that includes moisture. With any of the humidity treatments, it is possible to develop excellent self-epitaxy of the cap layer on the interlayer of IBAD-MgO.
In the case of performing the humidity treatment on the interlayer of IBAD-MgO, it is preferable that the humidity treatment be performed for 10 minutes or more. It is possible to obtain a cap layer of 7° or less at ΔΦ (220) as the value of ΔΦ if the treatment is performed for 10 minutes or more.

### BRIEF DESCRIPTION OF THE DRAWINGS

FIG. 1 is a cross-sectional view that shows a substrate for an oxide superconductor according to an embodiment of the present invention.
FIG. 2 is a cross-sectional view that shows an oxide superconductor according to an embodiment of the present invention using the substrate for an oxide superconductor shown in FIG. 1.
FIG. 3 is a configuration view that shows an example of the humidifier that is used in manufacturing the substrate for an oxide superconductor shown in FIG. 1.
FIG. 4 is a configuration view that shows another example of the humidifier that is used in manufacturing the substrate for an oxide superconductor shown in FIG. 1.
FIG. 5 is a view that shows the correlation between the value of ΔΦ (220) of a cap layer and the treatment time for samples that are obtained by forming a cap layer of CeO₂ on each of: an interlayer of IBAD-MgO with a humid air exposure treatment; an interlayer of IBAD-MgO with a humid Ar gas exposure treatment; an interlayer of IBAD-MgO with dry Ar gas exposure treatment; and an interlayer of IBAD-MgO without a humidity treatment.
FIG. 6 is a view that shows the correlation between the value of ΔΦ (220) of the cap layer of CeO₂ and the film thickness of the CeO₂ that is formed on each of: an interlayer of IBAD-MgO of a three-layered structure substrate with a humidity treatment performed on the interlayer; an interlayer of IBAD-MgO of a three-layered structure substrate without a humidity treatment; and an interlayer of IBAD-MgO of a four-layered structure substrate having an LMO layer interposed therein with a humidity treatment performed on the interlayer.
FIG. 7 is a view that shows the structure of a conventional example of an oxide superconductor that is provided with an interlayer formed by IBAD method.
FIG. 8 is a configuration view that shows the basic principle of IBAD method.
FIG. 9 is a configuration view that shows a first conventional example of a substrate for an oxide superconductor that is provided with an interlayer of IBAD-MgO.
FIG. 10 is a configuration view that shows a second conventional example of a substrate for an oxide superconductor that is provided with an interlayer of IBAD-MgO.
FIG. 11 is a configuration view that shows a third conventional example of a substrate for an oxide superconductor that is provided with an interlayer of IBAD-MgO.
FIG. 12 is a view that shows the correlation between the value of ΔΦ (220) of the cap layer and the film thickness in cases with and without LMO as the foundation of the cap layer of CeO₂ in the substrate for an oxide superconductor including an interlayer of IBAD-MgO.
FIG. 13 is a view that shows the results of secondary ion mass spectrometry on the surface of an interlayer of IBAD-MgO in samples manufactured in the examples.

### EMBODIMENTS FOR CARRYING OUT THE INVENTION

The embodiments of the present invention shall be described with reference to the drawings.

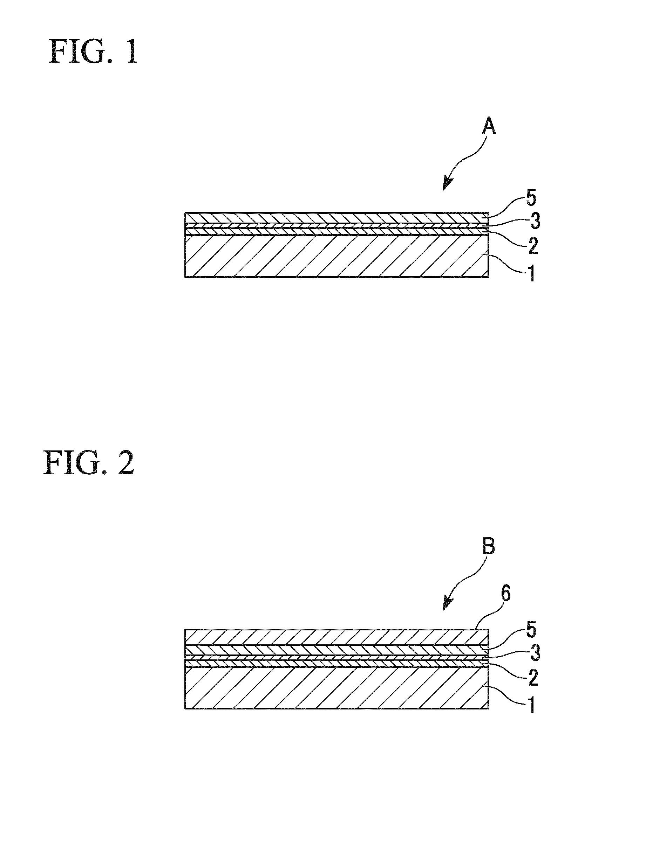

FIG. 1 shows a substrate for an oxide superconductor according to the first embodiment of the present invention. The substrate A for an oxide superconductor of the first embodiment mainly includes an elongated base 1, a diffusion prevention layer (bed layer) 2 that is formed by a deposition method such as sputtering on the base 1, an interlayer 3 that is fabricated by IBAD method on the diffusion prevention layer 2, and a cap layer 5 that is formed on the interlayer 3.
Also, FIG. 2 shows the oxide superconductor B that is obtained by forming an oxide superconductor layer 6 on the substrate A for the oxide superconductor of the first embodiment.

In the substrate A for an oxide superconductor of the present embodiment, as the constituent material of the elongated base 1, it is possible to use metals such as Cu, Ni, Ti, Mo, Nb, Ta, W, Mn, Fe, Ag and the like having excellent strength and heat resistance, or an alloy of these. What is particularly preferred is stainless steel, Hastelloy (registered trademark), or another nickel-based alloy having excellent corrosion resistance and heat resistance. The thickness of the elongated base 1 can be made 0.01 to 0.5 mm for use as an oxide superconductor wire.

A diffusion prevention layer 2 is formed on the base 1 in order, for example, to prevent the diffusion of elements during heat treatment. The constituent material of the diffusion prevention layer 2 has high heat resistance in order to reduce interfacial reactivity, and functions so as to obtain the orientation of the thin-film interlayer 3 that is disposed thereon. The diffusion prevention layer 2 is arranged if needed, and for example made of GZO (Gd₂Zr₂O₇), yttria (Y₂O₃), silicon nitride (Si₃N₄), aluminum oxide (Al₂O₃, "alumina"), etc. The diffusion prevention layer 2 is formed, for example by sputtering, and is formed with a thickness of, for example, several 10s to 200 nm.

The interlayer 3 is a thin film that is formed by ion beam assisted deposition (IBAD method). Examples of the constituent materials of the interlayer 3 include MgO, GZO (Gd₂Zr₂O₇), YSZ (yttria stabilized zirconia), and SrTiO₃. Among these, it is preferable to select a material which exhibits the value of the half-value width (full width at half maximum (FWHM)) ΔΦ (220) of the crystal axis dispersion in the in-plane direction, which is an index representing the crystal orientation, becomes smaller, that is, a material that can improve the in-plane crystal orientation. The thickness of the interlayer 3 is formed for example in a range of 1 nm to 1000 nm (1.0 µm). It is not expected that the thickness of the interlayer 3 of more than 1.0 µm contributes to further improvements in the crystal orientation. Rather, the increase of film formation time is economically disadvantageous. On the other hand, when the thickness of the interlayer 3 is less than 1 nm, it becomes too thin, and there is a risk of not being able to produce a film. For example, in the case of using IBAD-MgO as the interlayer 3, an interlayer with the value of the half-value width (FWHM: full width at half maximum) ΔΦ of 10° to 15°at ΔΦ (220) can be used. In the present invention, even if ΔΦ is not comparatively better, it is possible to attain the target crystal orientation by generating an excellent self-epitaxy effect in the target cap layer 5 through a humidity treatment described below. It is possible to obtain the ΔΦ of the interlayer 3 a crystal orientation of 10° or less at ΔΦ (220) by improving the IBAD method accuracy, but in that case, the fabrication conditions become strict, and so the productivity decreases. According to the above-described improvements, it is possible to obtain a cap layer 5 of the target orientation in the present invention even with an IBAD-MgO of around 10° to 20°, or 10° to 18° at ΔΦ (220).

The cap layer 5 has a function that controls the orientation of an oxide superconductor layer 6 that is provided thereon, and has a function of inhibiting the diffusion of the elements that constitute the oxide superconductor layer 6 to other layers.
It is preferable that the cap layer 5 be a self orienting thin film that is formed through a process of being epitaxially grown on the surface of the interlayer 3 by IBAD method, with the crystal grain being overgrown in the lateral direction (surface direction) to be selectively grown in the in-plane direction. In such a cap layer that is selectively grown, an in-plane orientation higher than that of the interlayer 3 is obtained. For example, even in the case of the ΔΦ (220) of the IBAD-MgO being around 10° to 20° or 10° to 18°, it is possible to obtain the cap layer 5 with ΔΦ of 7° or less.

The material that constitutes the cap layer 5 is not particularly limited provided it is capable of providing such effects, and preferred examples include CeO₂, LMO (LaMnO₃), SrTiO₃, Y₂O₃, Al₂O₃ or the like.
In the case of using CeO₂ as the constituent material of the cap layer 5, the cap layer 5 need not be entirely constituted by CeO₂, and may include a Ce-M-O-based oxidized material in which a portion of the Ce is replaced with another metal atom or metal ion.
The appropriate film thickness of the cap layer 5 differs depending on the constituent material, and for example in the case of constituting the cap layer 5 with CeO₂, an example of the thickness is in a range of 50 to 1000 nm.
The cap layer 5 can be formed by PLD or sputtering, but it is preferable to use PLD on the point of obtaining a fast film formation rate. Formation conditions of the CeO₂ layer by PLD may be a laser energy density of 1 to 5 J/cm² with a base temperature of approximately 500°C to 800°C in an oxygen gas atmosphere of approximately 0.6 to 40 Pa.

It is possible to employ an RE-123-based oxide superconductor (REBa₂Cu₃O_{7-X}: RE being a rare-earth element such as La, Nd, Sm, Eu, Gd) as the oxide superconductor layer 6. Among RE-123-based oxide superconductors, Y123 (YBa₂Cu₃O_{7-X}) or Gd123 (GdBa₂Cu₃O_{7-X}), or the like may be used, and it is of course possible to use other oxide superconductors, for example, one consisting of an oxide superconductor material with a high critical temperature represented by (Bi, Pb)₂Ca₂Sr₃Cu₄Oₓ. The thickness of the oxide superconductor layer 6 is 0.5 to 5 µm, and is preferably uniform. It is possible to form the oxide superconductor layer 6 by a deposition method such as PLD, sputtering, or TFA-MOD (trifluoroacetate-metalorganic deposition, coating-pyrolysis process).
The film quality of the oxide superconductor layer 6 is preferably uniform, and the oxide superconductor layer 6 is epitaxially grown and crystallized so that the c axis, a axis, and b axis of the crystal of the oxide superconductor layer 6 match the crystal of the cap layer 5, and the crystal orientation is excellent.

In the oxide superconductor B of the present embodiment, the structural characteristic is that an Mg hydroxide such as Mg(OH)₂ or an Mg compound such as MgCO₃ exists in the interface between the interlayer 3 of MgO by IBAD method (hereinbelow referred to as an interlayer of IBAD-MgO) and the cap layer 5, or the grain boundary of MgO. The Mg hydroxide or Mg compound such as Mg(OH)₂ or MgCO₃ is produced by performing a humidity treatment on the surface of the interlayer 3 of IBAD-MgO.

As a first example of a method of performing a humidity treatment on the surface of the interlayer 3 of IBAD-MgO, it is possible to employ a method including, after forming the diffusion prevention layer 2 and the interlayer 3 of IBAD-MgO on the base 1, housing the entirety in a container, and supplying an inert gas mixed with moisture to the container to perform exposure for a predetermined time.
As a second example of a method of performing a humidity treatment on the surface of the interlayer 3 of IBAD-MgO, it may be possible to perform a method including, after forming the diffusion prevention layer 2 and the interlayer 3 of IBAD-MgO on the base 1, exposing the entirety in air including moisture for a predetermined time. Note that another example may be a process that exposes it for a predetermined time in an inert gas atmosphere that includes moisture.

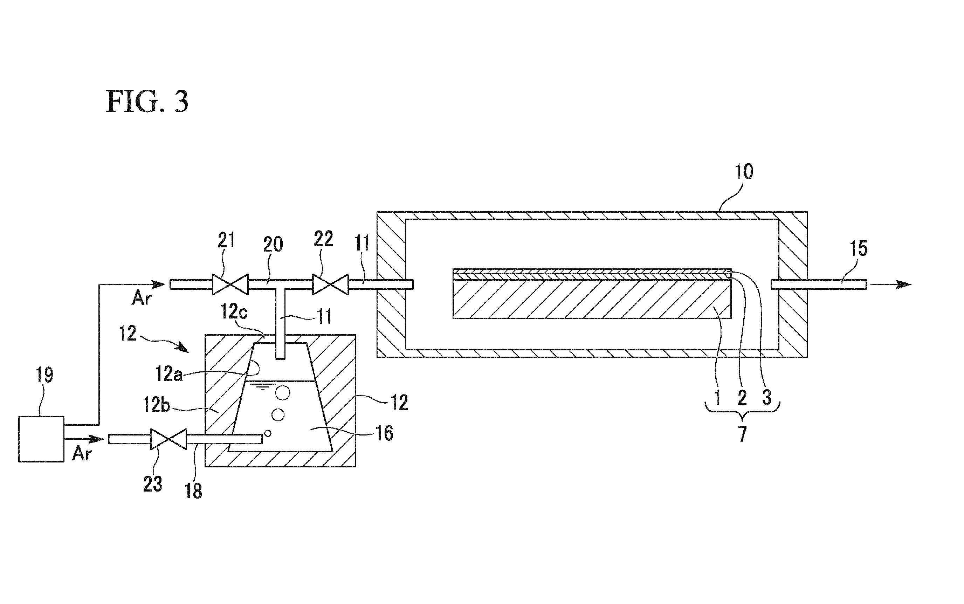

An example of a device that performs the aforementioned first humidity treatment is shown in FIG. 3. The humidity treatment device of the example mainly includes: an encapsulated container 10 that houses a laminate 7 that consists of the base 1 and the diffusion prevention layer 2 and the interlayer 3 of IBAD-MgO that are formed on the base 1; and a container-shaped humidifier 12 that is connected to the container 10 via a gas supply pipe 11. Although not shown in the figures, a heater is attached to the container 10 and the humidifier 12, whereby the container 10 and the humidifier 12 are individually heated and maintained at a desired temperature.
The container 10 has an opening/closing door not illustrated. The opening/closing door is opened, the laminate 7 is placed in the container 10, and then the opening/closing door is closed to seal it in. Along with the gas supply pipe 11 that is connected to the humidifier 12 at one end of the container 10, an exhaust pipe 15 is connected to the other end of the container 10. Thereby, the humidity treatment device of the example is configured so that humidification gas supplied from the humidifier 12 fills the interior of the container 10, and then the humidification gas is discharged to outside from the exhaust pipe 15.
The container 10 is shown as a container that houses and seals the laminate 7 with a predetermined length in the embodiment shown in FIG. 3. However, in the case of continuously humidifying an elongated laminate wound on a roll, it is possible for the container 10 to employ a structure which is formed to be longer in the lateral direction or the longitudinal direction than that shown in FIG. 3, and in which the elongated laminate that is supplied from the roll being drawn from one end of the container to an inner side and thus the humidity treatment can be continuously performed while the elongated laminate successively passes through the container. A container structure may be employed that uses a large container 10 with a plurality of direction-changing rolls provided therein, whereby it is possible to move the elongated laminate back and forth across multiple lanes in the container interior. In this case, even for a elongated laminate, it is possible to continuously perform the humidity treatment without hindrance.

The humidifier 12 is formed in a tank shape, and is configured to be able to house water 16 such as distilled water in the store portion 12a that is formed in the interior. A gas supply pipe 18 is connected at a side portion 12b of the humidifier 12, which penetrates the side portion 12b and projects into the store portion 12a. The gas supply pipe 18 is connected to an inert gas supply source 19 such as Ar gas, and configured so as to supply the inert gas to the inside of the humidifier 12. At a ceiling portion 12c of the humidifier 12, a gas supply pipe 11 that is connected to the container 10 is connected, and a branch pipe 20 is connected in the middle of the gas supply pipe 11. The branch pipe 20 is connected to the aforementioned inert gas supply source 19.
An opening and closing valve 21 is incorporated in the middle portion of the branch pipe 20, an opening and closing valve 22 is incorporated in the middle portion of the gas supply pipe 11, and an opening and closing valve 23 is incorporated in the middle portion of the gas supply pipe 18.

To perform the humidifying treatment on the IBAD-MgO interlayer 3 using the humidifier that has the aforementioned structure, first the laminate 7 is housed in the container 10, and water 16 such as distilled water is housed in the humidifier 12 as shown in FIG. 3. After releasing the opening and closing valves 21, 22, and 23, inert gas, such as Ar gas, is supplied from the inert gas supply source 19 to the inside of the water 16 via the gas supply pipe 18 while bubbling, and then supplied to the inside of the container 10 via the gas supply pipe 11. By this operation, humidity treatment is performed that exposes the laminate 7 in the container 10 for a predetermined time to the inert gas having a predetermined humidity, and an Mg hydroxide of Mg(OH)₂ and an Mg compound of MgCO₃ is formed on the surface of the interlayer 3 of IBAD-MgO.
During the humidity treatment, it is preferable to keep the interior of the container 10 at 25°C to 60°C, and it is preferable the interior of the humidifier 12 be adjusted in a temperature range of 21°C to 56°C.
During the humidity treatment, it is preferable that the interior of the container 10 be adjusted to a humidity range of 60% to 90%.
Moreover, it is desirable for the humidity treatment time to be 10 minutes or more in order to achieve the object, and it can be 10 minutes or more and up to around 3 hours. However, even if the humidity treatment is performed for a longer time than required, the effect is saturated and the processing time becomes of no use, so the time of the humidity treatment is preferably in a range of 30 minutes to 60 minutes.

After the humidity treatment, the laminate 7 is removed from the container 10, and the cap layer 5 of CeO₂ is formed on the interlayer 3 of IBAD-MgO by PLD (pulse laser deposition) or sputtering. As formation conditions of the CeO₂ layer by PLD, it can performed under the conditions of a laser energy density of 1 to 5 J/cm²with a base temperature of 500°C to 800°C in an oxygen gas atmosphere of approximately 0.6 to 40Pa.
During the formation of the cap layer 5, since the surface of the interlayer 3 of IBAD-MgO has been subjected to the humidity treatment, the crystal orientation of the cap layer 5 occurs with a better orientation than that of the interlayer 3 of IBAD-MgO. For example, if the value of the half-value width (FWHM: full width at half maximum) ΔΦ of the crystal axis dispersion in the in-plane direction, which is an index representing the crystal orientation property of the interlayer 3 of IBAD-MgO, being 10° to 20° at ΔΦ (220), the cap layer 5 of CeO₂ formed directly on the interlayer 3 normally exhibits a low self-epitaxy. Accordingly, in the conventional art, by forming a foundation layer of LMO (LaMnO₃) on the interlayer of IBAD-MgO, and then forming the cap layer of CeO₂ thereon, a cap layer having the target ΔΦ value of around 5° is obtained. However, according to the present embodiment, by performing the aforementioned humidity treatment, it is possible to obtain a strong self-epitaxy in the cap layer of CeO₂ even if the foundation layer of LMO (LaMnO₃ is omitted. Even if the cap layer 5 of CeO₂ is formed directly on the interlayer 3 of IBAD-MgO, the cap layer 5 is obtained having the target ΔΦ value of 7° or less, for example, around 5° (4° to 6°).

With regard to being able to obtain the target ΔΦ value of around 7° by forming the cap layer 5 of CeO₂ directly after the humidity process without forming the foundation layer of LMO (LaMnO₃) on the interlayer 3 of IBAD-MgO, the inventors are engaging various research, but it is confirmed by secondary ion mass spectrometry (SIMS) that an Mg hydroxide of Mg(OH)₂ and an Mg compound of MgCO₃ as well as MgO exist on the interlayer 3 of IBAD-MgO after the humidity treatment. Accordingly, due to the existence of those on the surface of the interlayer 3 of IBAD-MgO, it is estimated that the cap layer 5 of CeO₂ exhibits self-epitaxy with high efficiency, and thus a target ΔΦ value of 7° or less, preferably around 5° (for example, 4° to 6°) is obtained.
In the current state, since it is not possible to observe how the Mg(OH)₂ and the MgCO₃ exist on the interlayer 3 of IBAD-MgO, it is unclear how the Mg(OH)₂ and the MgCO₃ contribute to improvement of the self-epitaxy property of the cap layer 5. However, the existence of the Mg hydroxide of Mg(OH)₂ that can be presumed to have been generated by performing the humidity treatment can be presumed to contribute to an improvement in the self-epitaxy property of the cap layer 5.
Also, it can also be considered in the following manner. That is to say, H₂O reacting with MgO having poor orientation results in Mg(OH)₂, which remains as an impurity on the MgO having poor orientation. For that reason, CeO₂ is no longer epitaxially grown thereon. On the other hand, in the other portion (the MgO with good orientation), due to the CeO₂ epitaxial growth, CeO₂ with aligned orientation is formed, and that comes to occupy the entirety. Furthermore, H₂O reacting with MgO having poor orientation results in Mg(OH)₂. On the other hand, during formation of CeO₂, the H₂O detaches, whereby the Mg(OH)₂ returns to MgO, and the surface of the interlayer 3 is roughened. At the portion where the surface is roughened, the CeO₂ is not epitaxially grown, and at the other portions CeO₂ with aligned orientation is formed, and that comes to occupy the entirety, whereby CeO₂ with aligned crystal orientation is formed.

By forming the cap layer 5 of CeO₂ directly on the interlayer 3 of IBAD-MgO by performing the humidity treatment as described above, the cap layer 5 having the target ΔΦ value of 7° or less, for example around 5°, is obtained. Accordingly, with the oxide superconductor layer 6 formed on the cap layer 5 as shown in FIG. 2, the oxide superconductor B provided with the oxide superconductor layer 6 of the target high critical current density (for example, 3 MA/cm² or more) is obtained.
In the case of the oxide superconductor B with the laminate structure shown in FIG. 2, since it is possible to omit the foundation layer of LMO (LaMnO₃) that is provided between the interlayer of IBAD-MgO and the cap layer of CeO₂ in the conventional structure, it is possible to reduce the overall number of layers of the oxide superconductor B. As a result, it is possible to reduce the manufacturing cost, and it is possible to provide the oxide superconductor B at a lower price than before.

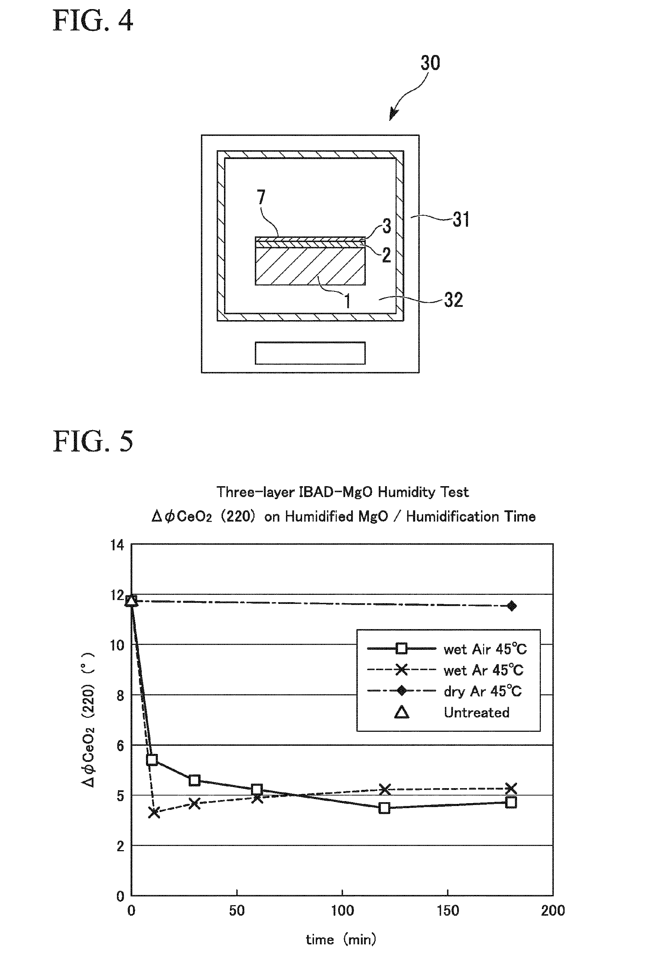

FIG. 4 is a view that shows a second example of the humidity treatment device that is used for performing the humidity treatment on the interlayer 3 of IBAD-MgO. The humidity treatment device of this example is constituted from a compact constant temperature and humidity chamber. The constant temperature and humidity chamber 30 of this aspect consists of a general purpose thermo-hygrostat including a storage room 32 that has a door and surrounded by an insulated wall 31, a heater, a fan, a humidifier, a condenser, and the like that are not illustrated. The temperature of the constant temperature and humidity chamber 30 can be adjusted between -40°C to +100°C with the ordinary configuration, and can be maintained at the target humidity (for example, 60% to 90%) while keeping the interior of the storage room 32 at the target temperature.

To carry out the humidity treatment on the interlayer 3 of IBAD-MgO using the constant temperature and humidity chamber 30, it may be arranged to place the laminate 7 in the storage room 32 as shown in FIG. 4, adjust the interior to the target temperature and humidity, and thereby perform the humidity treatment while exposing the interlayer 3 of IBAD-MgO to the air.
It is possible to perform a humidity treatment on the interlayer 3 of BAD- MGO through the above-described humidity treatment in the same manner as the device of the preceding example.
Since the humidity treatment device of the preceding example performs the humidity treatment using an inert gas, there is little risk of impurities becoming mixed in, but since the humidity treatment can also be performed by using the constant temperature and humidity chamber 30 that performs the humidity treatment exposing it to the air, it is possible to achieve the object of the present invention.
That is to say, the cap layer 5 having the target ΔΦ value of 7° or less, preferably around 5°, is obtained by forming the cap layer 5 of CeO₂ directly on the interlayer 3 of IBAD-MgO after the humidity treatment, without forming the foundation layer of LMO (LaMnO₃).

The humidity treatment that is performed in the present invention is not limited to the examples using the humidity treatment device shown in FIG. 3 and FIG. 4, and provided it is a treatment that is capable of supplying humidity onto the interlayer 3 of IBAD-MgO, the device and method to be used are not specified. For example, a general humidity treatment that entails atmospheric exposure in an atmosphere of high humidity at a plant or production site, a method of performing atomization of pure water or the like and drying, a method of performing immersion in pure water and drying, or the like may be employed.

### [Examples]

A plurality of laminate samples having a three-layer structure were fabricated, including a Gd₂Zr₂O₇ diffusion prevention layer with a thickness of 110 nm formed by ion beam sputtering on the surface of a Hastelloy 276 (registered trademark) tape-shaped metal base measuring 10 mm wide, 0.1 mm thick, and 6 cm long, and an interlayer of MgO (interlayer of IBAD-MgO) with a thickness of 5 nm formed thereon by ion beam assisted deposition method (IBAD method). Thereafter, performing the after-mentioned humidity treatment on each laminate sample, and then a cap layer of CeO₂ having a thickness of 500 nm is formed by pulse laser deposition, whereby a plurality of substrate samples for an oxide superconductor were fabricated. In these substrate samples, the ΔΦ, which is an index of the in-plane orientation of the used interlayer of IBAD-MgO, was 15° at ΔΦ (220).

The three-layer laminate that includes the metal substrate, the diffusion prevention layer, and the interlayer of IBAD-MgO was housed inside the container 10 shown in FIG. 3, and Ar gas was supplied as a carrier gas from the humidifier 12 to the container 10 at a rate of 10 ml/min. At this time, a humidity treatment was performed on each sample that includes performing a bubbling treatment that injects Ar gas into the distilled water 16 (3000 ml, 43°C) in the humidifier 12, adding 90% moisture to the Ar gas and supplying it to the container 10, and maintaining the interior of the container 10 at the humidity of 90% and the temperature of 45°C for each time duration (10 minutes, 30 minutes, 60 minutes, 120 minutes, 180 minutes). In addition, a sample of a three-layer laminate was also fabricated on which the humidity treatment was not carried out.

In the aforementioned sample with a three-layer structure (Hastelloy 276 (registered trademark) base + Gd₂Zr₂O₇ diffusion prevention layer + IBAD-MgO interlayer), the value of the ΔΦ of the cap layer CeO₂ that is formed on the interlayer of IBAD-MgO was measured for the obtained laminate sample in accordance with the humidity treatment time. The result is shown in FIG. 5. Note that the value of ΔΦ that is an index of the orientation is a value that was measured from the X-ray pole figure measurement of CeO₂ (220).

As is clear from the result shown in FIG. 5, in the untreated sample, and the sample that is exposed to dry Ar gas (45°C) that does not include moisture, the value of ΔΦ of the cap layer of CeO₂ is 11.5°, and that value was not changed. Accordingly, if the cap layer of CeO₂ is directly laminated after exposing to the dry Ar gas the interlayer of IBAD-MgO with ΔΦ = 11.5°, the self-epitaxy is weak, and the orientation of the cap layer of CeO₂ does not improve.
In contrast to this, in the sample that is exposed to air that includes moisture, or the sample that is exposed to Ar gas that includes moisture, the orientation of the cap layer of CeO₂ of the sample dramatically improves (the value of ΔΦ (220) becomes smaller) after a 10 minute-humidity treatment, whereby it is evident that the self-epitaxy effect is developed. From the result shown in FIG. 5, if a humidity treatment of 10 minutes or more is performed, with respect to the orientation, a cap layer of 7° or less, for example of around 5° (4° to 6°), is obtained at ΔΦ (220) in the cap layer. In particular, in the case of performing the humidity treatment for 30 minutes or more, it is clear that a cap layer with an excellent orientation of 5.5° or less is obtained in any of the samples exposed to humid air or the samples exposed to humid Ar gas. Note that since the ΔΦ (220) is 4° in the case of being exposed for 10 minutes to a humid Ar gas atmosphere (samples that are maintained for 10 minutes are denoted by the x mark in FIG. 5), in order to enhance the effect by as short a humidity treatment time as possible, exposure to a humid Ar gas atmosphere is considered more desirable than to the air.

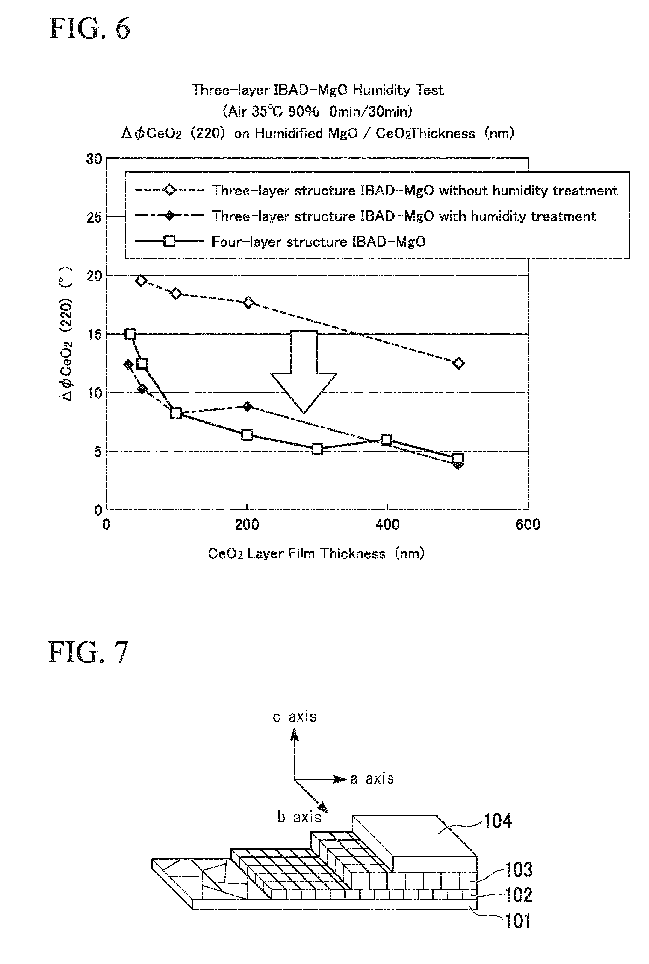

Next, in the aforementioned samples with the three-layer structure (Hastelloy 276 base + Gd₂Zr₂O₇ diffusion prevention layer + IBAD-MgO interlayer), the film thickness dependency of ΔΦ was tested in the case of a cap layer of CeO₂ being formed on the interlayer of IBAD-MgO, for the samples with and without a humidity treatment. The results are shown in FIG. 6. Moreover, for the aforementioned samples with a three-layer structure (Hastelloy 276 base + Gd₂Zr₂O₇ diffusion prevention layer + IBAD-MgO interlayer), a sample was fabricated with an LMO (LaMnO₃) foundation layer with a thickness of 6 nm formed on the interlayer of IBAD-MgO by sputtering, and the results of measuring the film thickness dependency of ΔΦ in the case of forming a cap layer of CeO₂ on the foundation layer of the sample are also shown in FIG. 6.

As shown in FIG. 6, the sample subjected to humidity treatment exhibits a ΔΦ value nearly the same as the sample in which an LMO (LaMnO₃) foundation layer with a thickness of 6 nm is formed on the interlayer of IBAD-MgO by sputtering. In addition, when the film thickness of the cap layer of CeO₂ is in the range of 300 to 500 nm, an excellent ΔΦ of 7° or less, for example around 5° (4° to 6°) is obtained. Accordingly, even if the LMO (LaMnO₃) foundation layer is not formed on the interlayer of IBAD-MgO, it is confirmed that the cap layer having a ΔΦ of around the targeted 5° can be formed by performing the humidity treatment.
From the above, since it is possible to obtain the target orientation with a substrate in which a cap layer of CeO₂ is directly formed on the interlayer of IBAD-MgO after a humidity treatment without forming a LMO (LaMnO₃) foundation layer, it is evident that it is possible to provide a substrate for an oxide superconductor that can be manufactured at low cost.

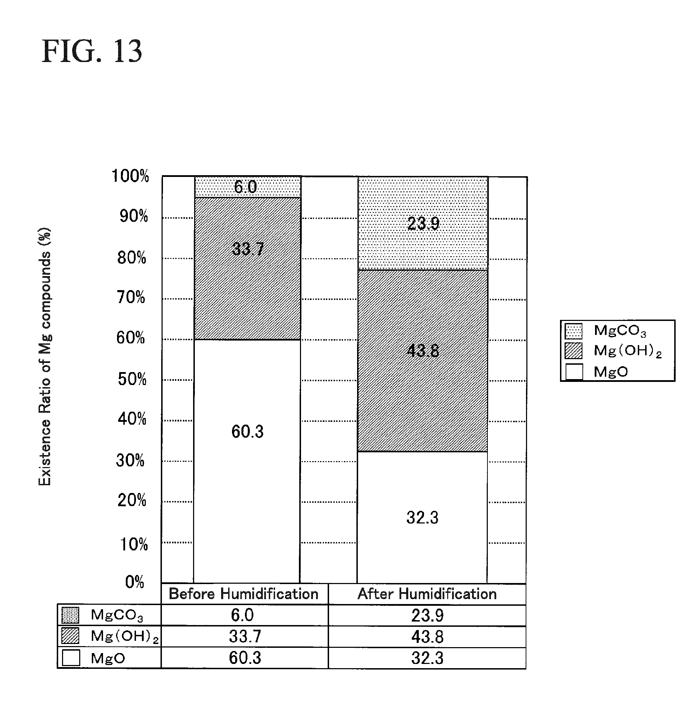

Next, secondary ion mass spectrometry (SIMS) was performed on the surface of the interlayer of IBAD-MgO after humidity treatment, for the sample shown in FIG. 5 (Wet Air 45°C 30 min) among the aforementioned examples. The results are shown in FIG. 13.
From the results of the secondary ion mass spectrometry shown in FIG. 13, it is confirmed that the existence ratio of Mg(OH)₂ and MgCO₃ on the surface of the interlayer of IBAD-MgO improves due to the humidity treatment. Accordingly, it becomes clear that the improvement in the existence ratio of Mg(OH)₂ and MgCO₃ that are formed on the surface of the IBAD-MgO layer due to the humidity treatment contributes to the development of self-epitaxy of the cap layer of CeO₂. Alternatively, it is considered that the existence ratio of Mg(OH)₂, MgCO₃ and MgO on the surface or grain boundary of the interlayer of IBAD-MgO due to the humidity treatment being in a suitable relationship also contributes. Note that with regard to Mg(OH)₂ and MgCO₃ being already detected in the samples during the secondary ion mass spectrometry prior to the humidity treatment, it is currently not clear whether this is due to the effects of once handling the samples in the open air for analysis, the effects of removing them from the film formation environment to the open air after film formation by IBAD method, or already being in the state of FIG. 13 before IBAD execution. In any case, due to the humidity treatment, it is presumed that the existence ratio of Mg(OH)₂, MgCO₃ and MgO on the surface or grain boundary of the interlayer of IBAD-MgO are in a relation suitable to the self alignment of the cap layer.

Next, in each sample in which a cap layer of CeO₂ with a thickness of 500 nm is formed shown in FIG. 6, an oxide superconductor layer with a thickness of 1.2 µm having a composition consisting of Gd₁Ba₂Cu₃Oₓ was formed by pulse laser deposition on the cap layer, whereby the oxide superconductor sample was fabricated.
The critical current density value (Jc) of each of the obtained oxide superconductor was measured at the measurement conditions of 77K, 0T, which reveals it is possible to obtain a value of 3 MA/cm² or more for any oxide superconductor sample.

### INDUSTRIAL APPLICABILITY

According to the present invention, without a foundation layer of LMO (LaMnO₃) that is provided on the interlayer of IBAD-MgO in a conventional structure, a cap layer having excellent self-epitaxy can be obtained. Accordingly, it is possible to provide a substrate for an oxide superconductor in which the crystal in-plane orientation of the cap layer is excellent. In addition, since it is possible to omit the foundation layer of LMO (LaMnO₃) that is provided on the interlayer of IBAD-MgO in a conventional structure, the number of laminated layers is fewer, and so it is possible to provide a substrate for an oxide superconductor that can be made cheaper. Moreover it is possible to provide an oxide superconductor with excellent superconductivity including critical current density by providing an oxide superconductor layer on the cap layer having excellent crystal in-plane orientation.

### DESCRIPTION OF REFERENCE NUMERALS

A substrate for oxide superconductor
B oxide superconductor
   1 metal base
   2 diffusion prevention layer (bed layer)
   3 interlayer of IBAD-MgO
   5 cap layer
   6 oxide superconductor layer
   10 container
   12 humidifier
   11, 18, 20 gas supply pipe
   19 inert gas supply source
   30 constant-temperature constant-humidity tank

## Claims

1. A substrate for an oxide superconductor comprising:
a metal base;
an interlayer of MgO formed on the metal base by ion beam assisted deposition method (IBAD METHOD); and
a cap layer that is formed directly on the interlayer and has a higher degree of crystal orientation than that of the interlayer,
wherein the interlayer of MgO is subjected to a humidity treatment prior to formation of the cap layer.

2. A substrate for an oxide superconductor comprising:
a metal base;
an interlayer of MgO formed on the metal base by ion beam assisted deposition method (IBAD METHOD); and
a cap layer that is formed directly on the interlayer and has a higher degree of crystal orientation than that of the interlayer,
wherein a hydroxide of Mg exists in the interface between the interlayer of MgO and the cap layer.

3. The substrate for an oxide superconductor according to claim 2, wherein Mg(OH)₂ or MgCO₃ exists in the interface between the interlayer of MgO and the cap layer, or the grain boundary of MgO.

4. An oxide superconductor according to claims 1 or 2, wherein a bed layer of oxide is interposed between the metal base and the interlayer.

5. An oxide superconductor according to claims 1 or 2, wherein the value of the half-value width (FWHM: full width at half maximum) ΔΦ of the crystal axis dispersion in the in-plane direction, which is an index representing the in-plane crystal orientation of the cap layer, is 7° or less at ΔΦ (220).

6. An oxide superconductor according to claim 1, wherein the humidity treatment is a treatment that is performed in an atmosphere including moisture.

7. An oxide superconductor according to claims 1 or 2, wherein the cap layer is CeO₂.

8. A process for producing a substrate for an oxide superconductor comprising: a metal base; an interlayer of MgO formed on the metal base by ion beam assisted deposition method (IBAD METHOD); and a cap layer that is formed directly on the interlayer and has a higher degree of crystal orientation than that of the interlayer, the process for producing a substrate for an oxide superconductor comprising:
forming a laminate by forming the interlayer of MgO on the metal base;
performing a humidity treatment on the laminate; and
forming the cap layer directly on the interlayer of MgO.

9. The process for producing a substrate for an oxide superconductor according to claim 8, wherein the humidity treatment is performed in an atmosphere that includes moisture.

10. The process for producing a substrate for an oxide superconductor according to claim 8, wherein the humidity treatment is performed for 10 minutes or more in an atmosphere of a 60% to 90% humidity and a temperature range of 25°C to 60°C.

11. The process for producing a substrate for an oxide superconductor according to claim 8, wherein the cap layer is formed from CeO₂.

12. An oxide superconductor comprising: the substrate for an oxide superconductor according to claims 1 or 2; and the oxide superconductor layer that is formed on the substrate for an oxide superconductor.

13. A process for producing an oxide superconductor comprising forming an oxide superconductor layer on the substrate for an oxide superconductor according to claim 8.
